(19) Europäisches Patentamt
European Patent Office
Office européen des brevets

(11) **EP 2 145 367 B1**

(12) **EUROPÄISCHE PATENTSCHRIFT**

(45) Veröffentlichungstag und Bekanntmachung des Hinweises auf die Patenterteilung:
**26.06.2019 Patentblatt 2019/26**

(21) Anmeldenummer: **07722419.4**

(22) Anmeldetag: **08.05.2007**

(51) Int Cl.:
*H02H 3/40* (2006.01)    *H02H 7/28* (2006.01)
*G01R 31/08* (2006.01)

(86) Internationale Anmeldenummer:
**PCT/DE2007/000870**

(87) Internationale Veröffentlichungsnummer:
**WO 2008/134998 (13.11.2008 Gazette 2008/46)**

(54) **VERFAHREN ZUM BESTIMMEN EINES EINE ERDIMPEDANZ ANGEBENDEN EINSTELLWERTES UND MESSEINRICHTUNG**

METHOD FOR DETERMINING AN ADJUSTMENT VALUE INDICATING A GROUND IMPEDANCE AND MEASUREMENT DEVICE

PROCÉDÉ POUR DÉTERMINER UNE VALEUR DE RÉGLAGE DONNANT L'IMPÉDANCE DE TERRE ET DISPOSITIF DE MESURE

(84) Benannte Vertragsstaaten:
**AT BE BG CH CY CZ DE DK EE ES FI FR GB GR HU IE IS IT LI LT LU LV MC MT NL PL PT RO SE SI SK TR**

(43) Veröffentlichungstag der Anmeldung:
**20.01.2010 Patentblatt 2010/03**

(73) Patentinhaber: **Siemens Aktiengesellschaft 80333 München (DE)**

(72) Erfinder:
• **KEREIT, Matthias 12159 Berlin (DE)**
• **SEZI, Tevfik 91052 Erlangen (DE)**

(56) Entgegenhaltungen:
**EP-A- 0 795 944      DE-C1- 4 441 334**
**US-A- 5 446 387      US-A- 6 097 280**

**Beschreibung**

Die Erfindung betrifft ein Verfahren zum Bestimmen eines Einstellwertes für ein elektrisches Schutzgerät, bei dem beim Auftreten eines Erdkurzschlusses mit einer ersten Messeinrichtung erste Stromzeigermesswerte und erste Spannungszeigermesswerte an einem ersten Ende eines Abschnitts einer elektrischen Energieversorgungsleitung und mit einer zweiten Messeinrichtung zweite Stromzeigermesswerte und zweite Spannungszeigermesswerte an einem zweiten Ende des Abschnitts der elektrischen Energieversorgungsleitung erfasst werden. Die Erfindung betrifft auch eine Messeinrichtung mit einer Erfassungseinrichtung, die zur Erfassung von an einem ersten Ende eines Leitungsabschnitts anstehenden ersten Stromzeigermesswerten und ersten Spannungszeigermesswerten eingerichtet ist, und einer Kommunikationseinrichtung, die zum Empfangen von mittels einer weiteren Messeinrichtung an einem zweiten Ende eines Leitungsabschnittes erfassten zweiten Stromzeigermesswerten und zweiten Spannungszeigermesswerten eingerichtet ist.

Zur Überwachung und zum Schutz elektrischer Energieversorgungsnetze werden üblicherweise sogenannte elektrische Schutzgeräte verwendet. Ein elektrisches Schutzgerät nimmt an einer Messstelle des elektrischen Energieversorgungsnetzes Messwerte auf, die einen Betriebszustand des elektrischen Energieversorgungsnetzes charakterisieren. Hierbei kann es sich beispielsweise um Strom- und Spannungsmesswerte handeln. Anhand dieser Messwerte und unter Verwendung spezieller Schutzalgorithmen trifft das Schutzgerät eine Entscheidung darüber, ob sich der von ihm überwachte Teil des elektrischen Energieversorgungsnetzes in einem zulässigen oder einem unzulässigen Betriebszustand befindet. Ein unzulässiger Betriebszustand liegt beispielsweise dann vor, wenn in dem überwachten Teil des elektrischen Energieversorgungsnetzes ein Kurzschluss aufgetreten ist. Liegt ein unzulässiger Betriebszustand vor, dann gibt das Schutzgerät üblicherweise automatisch einen sogenannten "Trip-Befehl" an einen ihm zugeordneten Leistungsschalter ab, der als Reaktion auf den Trip-Befehl seine Schaltkontakte öffnet und damit den fehlerbehafteten Abschnitt vom restlichen Energieversorgungsnetz abtrennt.

Ein häufig eingesetztes elektrisches Schutzgerät ist beispielsweise ein sogenanntes Distanzschutzgerät. Ein solches Distanzschutzgerät misst an einer Messstelle einer elektrischen Energieversorgungsleitung auftretende Ströme und Spannungen und berechnet daraus einen Impedanzwert der elektrischen Energieversorgungsleitung. Anhand des berechneten Impedanzwertes kann beispielsweise unter Zuhilfenahme bestimmter Kennlinien überprüft werden, ob ein Kurzschluss auf der elektrischen Energieversorgungsleitung aufgetreten ist. Das Distanzschutzgerät bestimmt hierbei anhand der gemessenen Ströme und Spannungen sozusagen einen Fehlerort, der den Ort angibt, an dem ein Kurzschluss auf der elektrischen Energieversorgungsleitung aufgetreten ist. Liegt der Fehlerort innerhalb des überwachten Abschnitts der elektrischen Energieversorgungsleitung, so gibt das Distanzschutzgerät einen Trip-Befehl an einen ihm zugeordneten Leistungsschalter ab, der daraufhin den fehlerbehafteten Abschnitt der elektrischen Energieversorgungsleitung von dem übrigen Energieversorgungsnetz abtrennt. Distanzschutzgeräte werden häufig zur Überwachung von elektrischen Energieversorgungsleitungen eingesetzt, weil sie eine hohe Selektivität aufweisen und in der Lage sind, autonome Entscheidungen zu treffen, ohne dass hierzu eine Kommunikation mit einem anderen Schutzgerät notwendig ist.

Kurzschlüsse können beispielsweise zwischen zwei oder drei Phasen der Energieübertragungsleitung (ein sogenannter "Leiter-Leiter-Kurzschluss") oder zwischen einer jeweiligen Phase und der elektrischen Erde (ein sogenannter "Leiter-Erde-Kurzschluss") auftreten. Im Falle eines Leiter-Leiter-Kurzschlusses zwischen zwei oder drei Phasen der elektrischen Energieversorgungsleitung kann die Berechnung des Fehlerortes sehr zuverlässig erfolgen, da die zur Fehlerortsberechnung benötigten Impedanzen der von dem Fehler betroffenen Leitungen üblicherweise bekannt sind.

Wesentlich häufiger als Leiter-Leiter-Kurzschlüsse finden jedoch Leiter-Erde-Kurzschlüsse statt, wobei es sich im Wesentlichen um einphasige Kurzschlüsse mit Erdbeteiligung handelt. Zur Berechnung des Fehlerortes bei solchen Leiter-Erde-Kurzschlüssen ist die Kenntnis der Erdimpedanz des Erdreiches notwendig, das an der von dem Distanzschutzgerät gemessenen Leiter-Erde-Schleife beteiligt ist.

Der für die Erdimpedanz verwendete Einstellwert, der als Parameter in dem elektrischen Distanzschutzgerät eingestellt werden muss, wird bisher beispielsweise aus Parametern der elektrischen Energieversorgungsleitung, wie beispielsweise der Nullsystemimpedanz und der Mitsystemimpedanz der elektrischen Energieversorgungsleitung, abgeleitet. Hierbei besteht die Gefahr von Rechenfehlern. Außerdem sind die auf diese Weise ermittelten Werte für die Erdimpedanz vergleichsweise ungenau, da die tatsächliche Erdimpedanz lediglich über für die Leitung gültige Daten abgeschätzt wird. Eine andere Möglichkeit besteht darin, Messungen der Erdimpedanz durchzuführen. Hierfür muss der entsprechende Abschnitt der elektrischen Energieversorgungsleitung abgeschaltet werden. Solche Messungen sind relativ teuer und aufwendig.

Generell ist ein Verfahren zum Ermitteln von Einstellwerten für elektrische Schutzgeräte beispielsweise aus der europäischen Patentanmeldung EP 0 795 944 A2 bekannt. Bei dem bekannten Verfahren werden Parameter der elektrischen Energieversorgungsleitungen durch Messung von Strömen und Spannungen an zwei Stellen der Leitung und Berechnung einer Kettenmatrix für die Energieversorgungsleitung bestimmt. Eine explizite Bestimmung der Erdimpedanz ist bei dem bekannten Verfahren jedoch nicht angesprochen.

Der Erfindung liegt daher die Aufgabe zugrunde, ein Verfahren und eine Messeinrichtung der oben genannten Art anzugeben, womit eine vergleichsweise einfache und genaue Bestimmung eines Einstellwertes für die Erdimpedanz möglich ist.

Hinsichtlich des Verfahrens wird die Aufgabe durch ein gattungsgemäßes Verfahren gelöst, bei dem unter Verwendung der ersten Strom- und Spannungszeigermesswerte und der zweiten Strom- und Spannungszeigermesswerte ein Fehlerortwert bestimmt wird, der einen Fehlerort angibt, an dem der Erdkurzschluss auf dem Abschnitt der elektrischen Energieversorgungsleitung aufgetreten ist, und unter Verwendung des Fehlerortwertes ein eine Erdimpedanz angebender Einstellwert berechnet wird.

Der Erfindung liegt die Erkenntnis zugrunde, dass bei einer zweiseitigen Fehlerortung, also der Berechnung eines Fehlerortes unter Verwendung von Strom- und Spannungszeigermesswerten, die an zwei Enden eines betroffenen Abschnittes einer geerdeten elektrischen Energieversorgungsleitung aufgenommen worden sind, keine Kenntnis der Erdimpedanz des beteiligten Erdreiches notwendig ist. Daher kann im Rahmen einer solchen zweiseitigen Fehlerortung ohne Kenntnis der Erdimpedanz ein Fehlerortwert bestimmt werden. Algorithmen für eine zweiseitige Fehlerortung sind in Fachkreisen allgemein bekannt. Beispielsweise kann die zweiseitige Fehlerortung wie in der deutschen Patentschrift DE 4441334 C1 beschrieben durchgeführt werden.

Anhand des durch die zweiseitige Fehlerortung ermittelten Fehlerortwertes kann in einem weiteren Schritt derjenige Wert für die Erdimpedanz bestimmt werden, der bei einer einseitigen Fehlerortung, also der Bestimmung des Fehlerortes durch ein Schutzgerät allein, zu demselben Fehlerort geführt hätte. Dieser Wert der Erdimpedanz kann als der gesuchte Einstellwert verwendet werden.

Der Einstellwert kann hierbei konkret gemäß der Gleichung

$$\underline{Z}_E = \frac{\underline{U}_A - \underline{I}_{AL} m \underline{Z}_L - \underline{U}_F}{m \underline{I}_{AE}}$$

bestimmt werden, wobei folgende Formelzeichen verwendet werden:

$\underline{Z}_E$ : Erdimpedanz;
$\underline{U}_A$ : von der ersten Messeinrichtung gemessener Spannungszeiger;
$\underline{I}_{AL}$ : von der ersten Messeinrichtung gemessener Stromzeiger;
m : Entfernung von der ersten Messeinrichtung zum Fehlerort bezogen auf die Länge des überwachten Abschnitts der Leitung;
$\underline{Z}_L$ : Mitsystemimpedanz des Abschnitts der Leitung;
$\underline{U}_F$ : Spannungsabfall am Fehlerort;
$\underline{I}_{AE}$ : von der ersten Messeinrichtung gemessener Erdstrom.

Eine vorteilhafte Ausführungsform des erfindungsgemäßen Verfahrens sieht vor, dass die ersten Strom- und Spannungszeigermesswerte von der ersten Messeinrichtung und die zweiten Strom- und Spannungszeigermesswerte von der zweiten Messeinrichtung zeitsynchron erfasst werden.

Hierdurch kann zur Berechnung des Fehlerortwertes ein einfacherer zweiseitiger Fehlerortungs-Algorithmus verwendet werden, da der Algorithmus keine nachträgliche Synchronisierung der ersten und zweiten Strom- und Spannungszeigermesswerte vornehmen muss.

In diesem Zusammenhang wird es als vorteilhaft angesehen, wenn die ersten und zweiten Strom- und Spannungszeigermesswerte mit einem Zeitstempel versehen werden, der denjenigen Zeitpunkt angibt, zu dem die jeweiligen Strom- und Spannungszeigermesswerte erfasst worden sind. Durch den Zeitstempel wird die Zuordnung der synchron erfassten Strom- und Spannungszeigermesswerte erleichtert.

In diesem Zusammenhang ist es außerdem vorteilhaft, wenn zur Erzeugung des Zeitstempels in der jeweiligen Messeinrichtung ein interner Zeitgeber verwendet wird. Ein solcher interner Zeitgeber kann beispielsweise durch einen Quarzoszillator getaktet werden.

Zur Synchronisierung der internen Zeitgeber der jeweiligen Messeinrichtungen kann vorteilhaft vorgesehen sein, dass die jeweiligen internen Zeitgeber der Messeinrichtungen über einen gemeinsamen externen Zeitgeber synchronisiert werden.

Ein solcher externer Zeitgeber kann beispielsweise ein GPS-Satellit sein, der ein regelmäßig gepulstes Signal aussendet.

Gemäß einer weiteren vorteilhaften Ausführungsform des erfindungsgemäßen Verfahrens kann vorgesehen sein, dass die erfassten zweiten Strom- und Spannungszeigermesswerte über eine Kommunikationsverbindung von der zweiten Messeinrichtung an die erste Messeinrichtung übertragen werden.

In diesem Fall kann vorgesehen sein, dass die erste Messeinrichtung den Fehlerortwert und den Einstellwert berechnet. Auf diese Weise kann eine der Messeinrichtungen selbst die Bestimmung des Einstellwertes vornehmen. Die Kommunikationsverbindung kann eine einfache Kommunikationsverbindung vergleichsweise geringer Datenübertragungskapazität sein und muss nicht notwendigerweise kontinuierlich bestehen, vielmehr kann auch die Einrichtung einer temporären Kommunikationsverbindung zur Übertragung der Strom- und Spannungszeigermesswerte ausreichen. Insbesondere ist es nicht notwendig, die Strom- und Spannungszeigermesswerte vor einer Abschaltung des Kurzschlusses zu übertragen, weil die Berechnung des Einstellwertes der Erdimpedanz üblicherweise nach der Abschaltung des Kurzschlusses stattfinden wird.

Alternativ hierzu kann gemäß einer anderen vorteilhaften Ausführungsform vorgesehen sein, sowohl die ersten Strom- und Spannungszeigermesswerte von der ersten Messeinrichtung an die zweite Messeinrichtung als auch die zweiten Strom- und Spannungszeigermesswerte von der zweiten Messeinrichtung an die erste Messeinrichtung über eine Kommunikationsverbindung zu übertragen.

In diesem Fall berechnen beide Messeinrichtungen den Fehlerortwert und den Einstellwert. Hierdurch wird eine redundante Berechnung des Einstellwertes erreicht, so dass durch den Vergleich der in beiden Messeinrichtungen bestimmten Einstellwerte die Gefahr einer falschen Bestimmung minimiert werden kann.

Eine weitere vorteilhafte Ausführungsform des erfindungsgemäßen Verfahrens sieht alternativ vor, dass sowohl die ersten Strom- und Spannungszeigermesswerte von der ersten Messeinrichtung als auch die zweiten Strom- und Spannungszeigermesswerte von der zweiten Messeinrichtung an eine Recheneinrichtung übertragen werden und die Recheneinrichtung den Fehlerortwert und den Einstellwert berechnet.

Auf diese Weise können als Messeinrichtungen vergleichsweise einfache Messeinrichtungen verwendet werden, die nicht über eine besonders hohe Rechenkapazität verfügen müssen. Die Berechnung des Fehlerortwertes und des Einstellwertes wird in einer externen Recheneinrichtung durchgeführt, an die die Messeinrichtungen ihre Strom- und Spannungszeigermesswerte übermitteln.

Gemäß einer weiteren vorteilhaften Ausführungsform des erfindungsgemäßen Verfahrens ist ferner vorgesehen, dass der Einstellwert zur Einstellung eines Erdimpedanzparameters eines elektrischen Distanzschutzgerätes verwendet wird.

Alternativ hierzu kann vorgesehen sein, dass für mehrere Erdkurzschlüsse jeweils ein Einstellwert berechnet wird und aus den berechneten Einstellwerten ein Mittelwert bestimmt wird, der zur Einstellung eines Erdimpedanzparameters eines Distanzschutzgerätes verwendet wird. Hierdurch wird eine Fehleinstellung des Einstellwertes für den Fall eines sogenannten "Ausreißers" vermieden, da zunächst ein Mittelwert über mehrere Einstellwerte, die bei unterschiedlichen Erdkurzschlüssen berechnet worden sind, bestimmt wird und dann der Mittelwert als Einstellwert verwendet wird.

Hinsichtlich der Messeinrichtung wird die oben genannte Aufgabe durch eine Messeinrichtung der eingangs genannten Art gelöst, wobei die Datenverarbeitungseinrichtung zur Berechnung eines den Ort eines Erdkurzschlusses auf dem Leitungsabschnitt angebenden Fehlerortwertes aus den erfassten ersten Strom- und Spannungszeigermesswerten und den empfangenen zweiten Strom und Spannungszeigermesswerten und zur Berechnung eines eine Erdimpedanz angebenden Einstellwertes aus dem Fehlerortwert eingerichtet ist.

Als besonders vorteilhaft wird in diesem Zusammenhang angesehen, wenn die Messeinrichtung ein elektrisches Distanzschutzgerät ist. In diesem Fall kann die Messwerterfassung des Distanzschutzgerätes auch zur Berechnung des Einstellwertes ausgenutzt werden; es wird keine separate Messeinrichtung benötigt.

Die Erfindung wird im Folgenden anhand von Ausführungsbeispielen näher erläutert. Hierzu zeigen

Figur 1    eine schematische Darstellung eines Abschnitts einer dreiphasigen Energieübertragungsleitung mit einer ersten und einer zweiten Messeinrichtung;

Figur 2    eine schematische Darstellung einer Phase eines Abschnitts einer dreiphasigen Energieübertragungsleitung;

Figur 3    eine schematische Darstellung zweier Messeinrichtungen, die über eine Kommunikationsverbindung mit einer Recheneinrichtung verbunden sind;

Figur 4    ein schematisches Blockschaltbild zur Erläuterung der Funktionsweise einer Messeinrichtung; und

Figur 5    ein schematisches Verfahrensfließbild zur Erläuterung eines Verfahrens zum Bestimmen eines eine Erdimpedanz angebenden Einstellwertes.

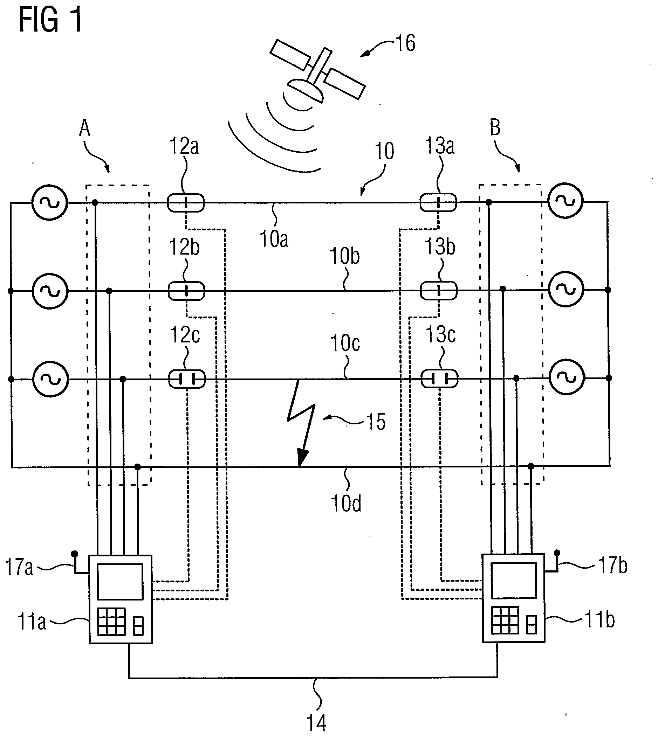

Figur 1 zeigt einen Abschnitt 10 einer im Weiteren nicht dargestellten geerdeten dreiphasigen Energieübertragungsleitung. Obwohl im Folgenden von einem dreiphasigen System ausgegangen wird, ist die Erfindung auch auf Systeme mit mehr oder weniger als drei Phasen anwendbar.

Der Abschnitt 10 umfasst eine erste Phase 10a, eine zweite Phase 10b und eine dritte Phase 10c. Mit dem Bezugszeichen 10d ist eine allen drei Phasen 10a, 10b, 10c gemeinsame elektrische Erde gekennzeichnet.

An einer ersten Messstelle A an einem ersten Ende des Abschnitts 10 ist eine Messeinrichtung in Form eines elektrischen Distanzschutzgerätes 11a angeordnet. In entsprechender Weise ist an einer zweiten Messstelle B an einem zweiten Ende des Abschnitts 10 eine zweite Messeinrichtung in Form eines zweiten Distanzschutzgerätes 11b angeordnet. Bei den Messeinrichtungen handelt es sich im dargestellten Beispiel gemäß Figur 1 um elektrische Distanzschutzgeräte 11a und 11b; es ist jedoch auch möglich, elektrische Messeinrichtungen ohne eine zusätzliche Schutzfunktion, beispielsweise sogenannte Zeigermessgeräte (im Englischen auch als Phasor Measurement Unit = PMU bezeichnet) an den Messstellen A und B einzusetzen.

Von jeder der drei Phasen 10a, 10b, 10c sowie der gemeinsamen elektrischen Erde 10d werden an der Messstelle A mittels lediglich schematisch angedeuteter Strom- und Spannungsmesswandler erste Strom- und Spannungszeigermesswerte erfasst und dem ersten Distanzschutzgerät 11a zugeführt. Entsprechend werden von jeder der drei Phasen 10a, 10b, 10c sowie der gemeinsamen elektrischen Erde 10d an der Messstelle B zweite Strom- und Spannungszeigermesswerte erfasst und dem zweiten Distanzschutzgerät zugeführt.

Die beiden Distanzschutzgeräte 11a und 11b sind dazu eingerichtet, anhand der aufgenommenen Strom- und Spannungszeigermesswerte einen Distanzschutzalgorithmus auszuführen und für den Fall, dass auf dem Abschnitt 10 der elektrischen Energieversorgungsleitung ein Fehler, wie beispielsweise ein Kurzschluss erkannt wird, ein Auslösesignal (Trip-Befehl) an entsprechende Leistungsschalter 12a, 12b und 12c an dem ersten Ende des Abschnitts 10 bzw. elektrische Leistungsschalter 13a, 13b und 13c an dem zweiten Ende des Abschnitts 10 abzugeben. Hierdurch werden die entsprechenden Leistungsschalter 12a, 12b, 12c bzw. 13a, 13b, 13c zum Öffnen ihrer Schaltkontakte veranlasst, um so die fehlerbehafteten Phasen der elektrischen Energieversorgungsleitung vom übrigen Energieversorgungsnetz zu isolieren.

Die Distanzschutzgeräte 11a und 11b sind ferner über eine Kommunikationsverbindung 14 miteinander verbunden, wobei die Kommunikationsverbindung sowohl kabelgebunden als auch drahtlos ausgeführt sein kann und nicht kontinuierlich zwischen den beiden Messeinrichtungen 11a und 11b bestehen oder aktiv sein muss. Beispielsweise ist es möglich, eine temporäre Kommunikationsverbindung in Form einer Funkverbindung zwischen den beiden Messeinrichtungen aufzubauen oder eine temporäre Telekommunikationsverbindung zwischen den beiden Messeinrichtungen über entsprechende Modemeinrichtungen aufzubauen. Bei der Kommunikationsverbindung kann es sich außerdem um eine Kommunikationsverbindung vergleichsweise geringer Datenübertragungskapazität handeln.

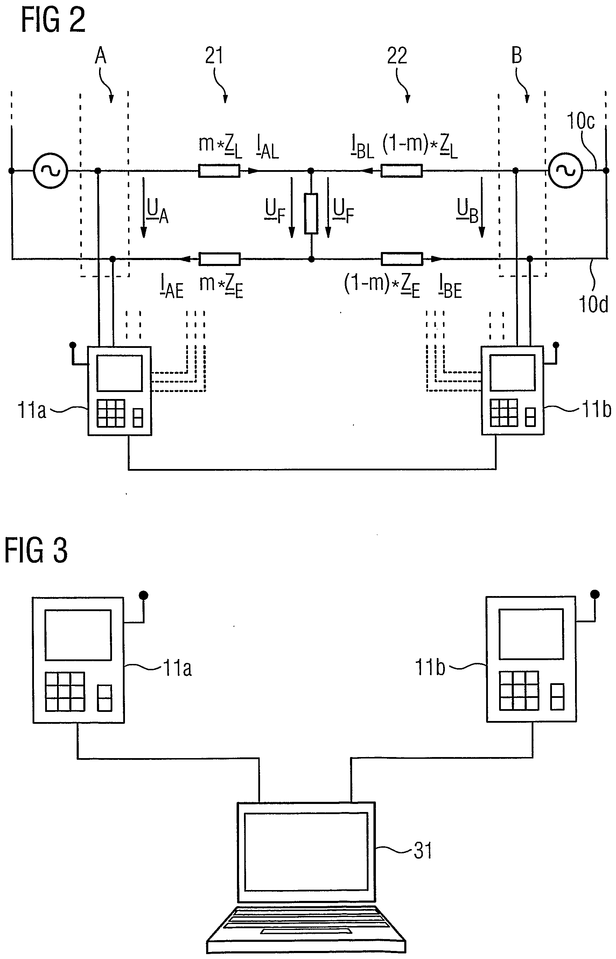

Die Funktionsweise des in Figur 1 dargestellten Systems soll im Folgenden anhand der Figuren 1 und 2 näher erläutert werden. Hierzu wird angenommen, dass zwischen der Phase 10c des Abschnitts 10 und der elektrischen Erde 10d ein in Figur 1 durch ein Blitzsymbol 15 angedeuteter Erdkurzschluss aufgetreten ist. Die Distanzschutzgeräte 11a und 11b erkennen den aufgetretenen Kurzschluss, indem sie kontinuierlich die Strom- und Spannungszeiger an den jeweiligen Messstellen A und B erfassen und mit diesen zunächst die Impedanzen aller vorhandenen Schleifen, also der drei Leiter-Leiter-Schleifen (Phase 10a zu Phase 10b, Phase 10a zu Phase 10c, Phase 10b zu Phase 10c) und der drei Phase-Erde-Schleifen (Phase 10a zu Erde 10d, Phase 10b zu Erde 10d und Phase 10c zu Erde 10d) berechnen. Durch den Vergleich der ermittelten Impedanzen mit im Gerät gespeicherten Kennlinien wird der Abschnitt 10 auf Fehler überprüft. Im Falle eines Fehlers wird die Fehlerart ermittelt, d. h., ob es sich um einen Leiter-Leiter-Kurzschluss oder einen Leiter-Erde-Kurzschluss handelt. Zusätzlich werden die an dem Fehler beteiligten Phasen bestimmt. Anhand der berechneten Impedanz kann außerdem auf den Fehlerort, an dem der Kurzschluss aufgetreten ist, geschlossen werden. Liegt ein Fehler vor, so werden die betroffenen Phasen über die zugehörigen Leistungsschalter 12a, 12b, 12c bzw. 13a, 13b, 13c vom übrigen Energieversorgungsnetz abgetrennt. In Figur 1 ist beispielhaft die von dem Erdkurzschluss betroffene Phase 10c des Abschnitts 10 der elektrischen Energieversorgungsleitung über die geöffnet dargestellten Leistungsschalter 12c und 13c abgeschaltet worden.

Im Falle eines Phase-Phase-Kurzschlusses kann die Fehlererkennung und die Fehlerortung vergleichsweise einfach durchgeführt werden, weil die Leitungsimpedanzen üblicherweise mit hoher Genauigkeit bekannt sind. Im Falle des in Figur 1 dargestellten Leiter-Erde-Kurzschlusses fließt der Kurzschlussstrom allerdings von der betroffenen Phase 10c über die elektrische Erde 10d zum jeweiligen Distanzschutzgerät 11a und 11b zurück. Die hierbei vorhandene Erdimpedanz ist üblicherweise nicht mit hoher Genauigkeit bekannt und musste bisher durch aufwändige Messungen, bei denen der Abschnitt 10 vom übrigen Netz abgetrennt sein musste, oder Abschätzungen bestimmt und als Parameter in dem jeweiligen Distanzschutzgerät eingegeben werden.

Im Folgenden soll daher ein Verfahren erläutert werden, wie es möglich ist, auf einfache Weise einen Einstellwert für die Erdimpedanz zu ermitteln, der vergleichsweise genau ist und keine Abschaltung des Abschnitts 10 der Energieübertragungsleitung erfordert.

Hierzu soll zunächst anhand von Figur 2 die Berechnung eines Fehlerortwertes m hergeleitet werden. Dieser Fehlerortwert m gibt den Ort an, an dem der Kurzschluss zwischen der Phase 10c und der elektrischen Erde 10d aufgetreten ist. Dafür wird die bekannte Maschenregel gemäß dem zweiten Kirchhoffschen Gesetz auf die in Figur 2 gezeigten Maschen 21 und 22, die jeweils zwischen dem Kurzschluss und dem jeweiligen Distanzschutzgerät 11a bzw.

11b vorliegen, angewendet. Hieraus ergibt sich für die Masche 21 zwischen dem ersten Distanzschutzgerät 11a und dem Kurzschluss folgende Maschengleichung (1) :

$$-\underline{U}_A + \underline{I}_{AL} \cdot m \cdot \underline{Z}_L + \underline{U}_F + \underline{I}_{AE} \cdot m \cdot \underline{Z}_E = 0 \qquad\qquad (1)$$

Hierbei bedeuten die Formelzeichen (vergleiche auch Figur 2):

$\underline{U}_A$:   den von dem ersten Distanzschutzgerät 11a gemessenen Spannungszeiger, der die Spannung zwischen der Phase 10c und der elektrischen Erde 10d angibt;

$\underline{I}_{AL}$:   den von dem ersten Distanzschutzgerät 11a gemessenen Stromzeiger, der den in der Phase 10c fließenden Strom angibt;

m:   die Entfernung von dem ersten Distanzschutzgerät 11a zum Fehlerort bezogen auf die gesamte Länge des Abschnitts 10;

$\underline{Z}_L$:   die Mitsystemimpedanz der Phase 10c des Abschnitts 10 der Leitung;

$\underline{U}_F$:   den Spannungsabfall am Fehlerort;

$\underline{I}_{AE}$:   den von dem ersten Distanzschutzgerät 11a gemessenen Erdstromzeiger, der den in der elektrischen Erde 10d fließenden Strom angibt; und

$\underline{Z}_E$:   die Erdimpedanz.

Für die zweite Masche 22 zwischen dem zweiten Distanzschutzgerät 11b und dem Kurzschluss kann in entsprechender Weise die Maschengleichung (2) aufgestellt werden:

$$-\underline{U}_B + \underline{I}_{BL} \cdot (1-m) \cdot \underline{Z}_L + \underline{U}_F + \underline{I}_{BE} \cdot (1-m) \cdot \underline{Z}_E = 0 \qquad\qquad (2)$$

Hierbei bedeuten die zusätzlichen Formelzeichen (vergleiche auch Figur 2):

$\underline{U}_B$:   den von dem zweiten Distanzschutzgerät 11b gemessenen Spannungszeiger, der die Spannung zwischen der Phase 10c und der elektrischen Erde 10d angibt;

$\underline{I}_{BL}$:   den von dem zweiten Distanzschutzgerät 11b gemessenen Stromzeiger, der den in der Phase 10c fließenden Strom angibt; und

$\underline{I}_{BE}$:   den von dem zweiten Distanzschutzgerät 11b gemessenen Erdstromzeiger, der den in der elektrischen Erde 10d fließenden Strom angibt.

Unter Verwendung der jeweiligen Gleichung kann das Distanzschutzgerät 11a bzw. 11b einen den Fehlerort angebenden Fehlerortwert m bestimmen. Hierzu müssen jedoch als Parameter die Einstellwerte für die Mitsystemimpedanz der Leitung und die Erdimpedanz in dem jeweiligen Distanzschutzgerät 11a bzw. 11b vorliegen.

Bei der ersten Inbetriebnahme der Distanzschutzgeräte 11a und 11b kann als Anfangswert für den Parameter der Erdimpedanz beispielsweise ein aus Erfahrungswerten abgeleiteter Einstellwert verwendet werden. Für die Ermittlung eines möglichen Anfangswertes kann somit beispielsweise der Erfahrungswert herangezogen werden, dass das Verhältnis sowohl des Realteils als auch des Imaginärteils zwischen der Nullsystemimpedanz und der Mitsystemimpedanz einer elektrischen Energieübertragungsleitung üblicherweise ungefähr bei 1 liegt. Hieraus lässt sich ein Einstellwert für die Erdimpedanz abschätzen, der zwar nicht hochgenau ist, aber auf jeden Fall die Funktionstüchtigkeit der Distanzschutzgeräte gewährleistet.

Im Betrieb nehmen die Distanzschutzgeräte 11a und 11b jeweils Strom- und Spannungszeigermesswerte auf und überprüfen, ob auf dem überwachten Abschnitt 10 ein Fehler aufgetreten ist. Tritt ein Erdkurzschluss auf einer Phase des Abschnitts 10 der elektrischen Energieversorgungsleitung auf, so wird zunächst die betroffene Phase vom übrigen elektrischen Energieversorgungsnetz über Leistungsschalter isoliert.

Nach erfolgreicher Abschaltung der betroffenen Phase der elektrischen Energieversorgungsleitung können die Strom- und Spannungszeigermesswerte, die zum Zeitpunkt des Erdkurzschlusses aufgenommen und in internen Datenspeichern der Distanzschutzgeräte gespeichert worden sind, über die Kommunikationsverbindung 14 zwischen den Distanzschutzgeräten 11a und 11b übertragen werden. Hierbei kann eine unidirektionale Übertragung stattfinden, bei der beispielsweise die von dem zweiten Distanzschutzgerät 11b aufgenommenen Strom- und Spannungszeigermesswerte an das erste Distanzschutzgerät übertragen werden. Alternativ kann auch eine bidirektionale Übertragung stattfinden, bei der beide Distanzschutzgeräte 11a und 11b ihre Strom- und Spannungszeigermesswerte an das jeweils andere Distanzschutzgerät übertragen. Da der Erdkurzschluss zu diesem Zeitpunkt bereits abgeschaltet ist, kann die Übertragung der jeweiligen Strom- und Spannungszeigermesswerte in beliebig langer Zeit erfolgen, so dass für die Kommunikationsverbindung 14 eine Verbindung mit vergleichsweise geringer Datenübertragungskapazität ausreichend ist.

Mit den eigenen zum Zeitpunkt des Erdkurzschlusses aufgenommenen Strom- und Spannungszeigermesswerten und den vom entfernten Ende des Abschnitts 10 aufgenommenen Strom- und Spannungszeigermesswerten kann daraufhin ein sogenannter zweiseitiger Fehlerortungsalgorithmus durchgeführt werden, mit dem sehr genau der Fehlerort, an dem der Erdkurzschluss aufgetreten ist, bestimmt werden kann. Hierzu sind aus dem Stand der Technik mehrere mögliche Fehlerortungsverfahren bekannt, beispielsweise kann der in der deutschen Patentschrift DE 4441334 C1 beschriebene zweiseitige Fehlerortungsalgorithmus verwendet werden. Unter Anwendung eines solchen zweiseitigen Fehlerortungsalgorithmus lässt sich der Fehlerortwert m bestimmen, der den auf die gesamte Leiterlänge bezogenen Fehlerort des Erdkurzschlusses angibt.

$$m = \frac{l_{A-F}}{l_{ges}} \tag{3}$$

Hierbei bedeuten:

$l_{A-F}$:     Strecke des Abschnitts 10 von der Messstelle A bis zum Fehlerort;
$l_{ges}$:     Länge des gesamten Abschnitts 10.

Der Vorteil der Anwendung eines solchen zweiseitigen Fehlerortungsalgorithmus liegt insbesondere darin, dass er auf Strom- und Spannungszeigermesswerte von beiden Enden des Abschnitts 10 zurückgreift und daher ohne Kenntnis der Erdimpedanz durchgeführt werden kann.

Mit dem über den zweiseitigen Fehlerortungsalgorithmus ermittelten Fehlerortwert m kann daraufhin in demjenigen Distanzschutzgerät, in dem die Stromzeigermesswerte von beiden Enden vorliegen (also bei unidirektionaler Übertragung in einem Distanzschutzgerät und bei bidirektionaler Übertragung in beiden Distanzschutzgeräten) unter Anwendung der entsprechenden Maschengleichung (1) bzw. (2) die Erdimpedanz bestimmt werden, die zu dem über den zweiseitigen Fehlerortungsalgorithmus berechneten Fehlerortwert m passt.

Mit anderen Worten wird hierbei diejenige Erdimpedanz berechnet, die bei Anwendung einer einseitigen Fehlerortung allein durch das erste oder zweite Distanzschutzgerät 11a oder 11b denselben Fehlerort ergeben hätte wie bei der zweiseitigen Fehlerortberechnung.

Hierzu wird beispielsweise Gleichung (1) für das erste Distanzschutzgerät derart umgestellt, dass sich folgende Gleichung (4) ergibt:

$$\underline{Z}_E = \frac{\underline{U}_A - \underline{I}_{AL} \cdot m \cdot \underline{Z}_L - \underline{U}_F}{m \cdot \underline{I}_{AE}} \tag{4}$$

Entsprechend wird durch Umstellung von Gleichung (2) für das zweite Distanzschutzgerät 11b folgende Gleichung (5) als Berechnungsgleichung der Erdimpedanz ermittelt.

$$\underline{Z}_E = \frac{\underline{U}_B - \underline{I}_{BL} \cdot (1 \cdot m) \cdot \underline{Z}_L - \underline{U}_F}{(1-m) \cdot \underline{I}_{BE}} \tag{5}$$

Einige Verfahren zur zweiseitigen Fehlerortung, wie beispielsweise das in der genannten Patentschrift DE 4441334 C1 beschriebene zweiseitige Fehlerortungsverfahren, liefern als Ergebnis auch einen Wert für den Spannungsabfall $\underline{U}_F$ am Fehlerort, so dass dieser Wert direkt in die jeweilige Berechnungsgleichung (4) bzw. (5) übernommen werden kann. Ist der Spannungsabfall $\underline{U}_F$ am Fehlerort nicht bekannt, so kann er ohne zu großen Einfluss auf das Endergebnis auch vernachlässigt werden.

Da die übrigen Werte, die für Gleichungen (4) bzw. (5) benötigt werden, entweder durch Messung oder als Leitungsparameter bekannt sind, kann problemlos die Erdimpedanz $Z_E$ bestimmt werden. Die auf diese Weise berechnete Erdimpedanz kann im Folgenden als Einstellwert für den Parameter Erdimpedanz in den Distanzschutzgeräten 11a und 11b verwendet werden.

Findet eine Berechnung des Erdimpedanzeinstellwertes in beiden Distanzschutzgeräten 11a und 11b statt, so können die beiden Ergebnisse für die Erdimpedanz miteinander verglichen werden. Treten zu hohe Abweichungen zwischen den beiden Ergebnissen auf, so kann vorgesehen sein, dass aufgrund der Unsicherheit der Ergebnisse die berechneten Einstellwerte verworfen und nicht als Parameter für die Distanzschutzgeräte 11a und 11b verwendet werden.

Es kann ferner vorgesehen sein, dass das Verfahren zur Berechnung der Erdimpedanzeinstellwerte zunächst durch Abwarten einiger Erdkurzschlüsse mehrfach durchgeführt wird und dann ein Mittelwert aus den mehreren berechneten Erdimpedanzeinstellwerten gebildet wird. In diesem Fall wird dann der Mittelwert als neuer Erdimpedanzeinstellwert für die Distanzschutzgeräte 11a und 11b verwendet.

Durch das beschriebene Verfahren kann ebenfalls eine kontinuierliche Anpassung des Einstellwertes für die Erdimpedanz stattfinden, um beispielsweise eine Veränderung des Erdreiches aufgrund unterschiedlicher Feuchtigkeitswerte oder anderer Einflussfaktoren zu berücksichtigen.

Ein besonderer Vorteil des beschriebenen Verfahrens besteht darin, dass die Berechnung des Einstellwertes für die Erdimpedanz nicht zeitkritisch durchgeführt wird, d. h. dass zunächst eine Auslösung der jeweiligen Leistungsschalter stattfindet, um den Fehler aus den elektrischen Energieversorgungsnetz abzutrennen und erst danach die Berechnung des Einstellwertes stattfinden muss. Hierdurch werden die Anforderungen an die Kommunikationsverbindung 14 vergleichsweise niedrig gehalten, da die Übertragungszeit zwischen den Distanzschutzgeräten 11a und 11b keine Rolle spielt.

Die Distanzschutzgeräte 11a und 11b können die Strom- und Spannungszeigermesswerte beispielsweise in nicht synchroner Weise aufnehmen. In diesem Fall muss als Algorithmus der zweiseitigen Fehlerortung ein solcher Algorithmus eingesetzt werden, der die Strom- und Spannungszeigermesswerte von den beiden Enden des Abschnitts 10 der elektrischen Energieversorgungsleitung sozusagen nachträglich synchronisiert und dann den Fehlerortwert m berechnet. Bei einem solchen Verfahren muss üblicherweise eine kontinuierliche Kommunikationsverbindung zwischen den Distanzschutzgeräten bestehen.

Es kann aber auch vorgesehen sein, dass die Distanzschutzgeräte 11a und 11b ihre Strom- und Spannungszeigermesswerte in zeitsynchroner Weise aufnehmen, d. h. dass die Abtastung in den beiden Distanzschutzgeräten synchron erfolgt. Hierzu weisen die Distanzschutzgeräte 11a und 11b jeweils interne Zeitgeber auf, die über einen externen Zeitgeber zueinander synchronisiert werden. Als externer Zeitgeber kann beispielsweise ein GPS-Satellit eingesetzt werden, der in regelmäßigen Abständen (z.B. im Sekundenabstand) ein Signal aussendet, aus dem ein absolutes Zeitsignal extrahiert werden kann. Die Distanzschutzgeräte synchronisieren ihre internen Zeitgeber auf den externen Zeitgeber, indem sie über Antennen 17a und 17b (vergleiche Figur 1) die GPS-Signale empfangen und mittels nicht gezeigten GPS-Empfängerbausteinen das Zeitsignal aus dem GPS-Signal extrahieren. Anstelle eines GPS-Signals kann auch ein beliebiges anderes extern erzeugtes Zeitsignal verwendet werden.

Den Strom- und Spannungszeigermesswerten wird zusätzlich ein Zeitstempel zugeordnet, der den Zeitpunkt ihrer Erfassung beispielsweise auf eine Mikrosekunde genau angibt, so dass eine Zuordnung der zueinander gehörenden Strom- und Spannungszeigermesswerte von beiden Enden des Abschnitts 10 für das zweiseitige Fehlerortungsverfahren in einfacher Weise möglich ist. Der Zeitstempel wird gemeinsam mit den jeweiligen Strom- und Spannungszeigermesswerten zwischen den Distanzschutzgeräten 11a und 11b übertragen. Bei solchen zeitgestempelten Strom- und Spannungszeigermesswerten ist auch eine lediglich temporär bestehenden Kommunikationsverbindung zwischen den Distanzschutzgeräten ausreichend. Besteht keine Kommunikationsverbindung zwischen den Distanzschutzgeräten, so ist es in diesem Fall auch möglich, die Strom- und Spannungszeigermesswerte manuell mit einem Datenträger zwischen den Distanzschutzgeräten zu übermitteln.

Obwohl im Zusammenhang mit den Figuren 1 und 2 als Messeinrichtungen Distanzschutzgeräte 11a und 11b eingesetzt werden, ist es für das beschriebene Verfahren zur Berechnung eines Einstellwertes für die Erdimpedanz nicht notwendig, dass die Strom- und Spannungszeiger mit Distanzschutzgeräten gemessen werden oder die Berechnung des Fehlerortwertes und des Einstellwertes in einem Distanzschutzgerät stattfinden. Vielmehr können hierzu auch sogenannte Zeigermessgeräte (Phasor Measurement Units: PMUs) eingesetzt werden, die als Messgeräte an die Stelle der Distanzschutzgeräte 11a und 11b treten. In diesem Fall besitzen die Zeigermessgeräte lediglich Messeingänge, um die Strom- und Spannungszeiger aufzunehmen, aber keinen Kommandoausgang, um ein Auslösesignal an entsprechende Leistungsschalter abzugeben. Ein auf diese Weise mit Zeigermessgeräten bestimmter Einstellwert muss anschließend beispielsweise manuell in den Distanzschutzgeräten eingegeben werden.

In Figur 3 ist eine alternative Möglichkeit gezeigt, bei der die Distanzschutzgeräte 11a und 11b nicht selbst die Berechnung des Einstellwertes vornehmen, sondern die gemessenen Strom- und Spannungszeigermesswerte an eine externe Recheneinrichtung 31 übermitteln. Bei dieser kann es sich beispielsweise um einen tragbaren Computer wie einen Laptop oder einen Computer in einer Leitwarte handeln. Die Übertragung kann entsprechend zu dem in Figur 1 dargestellten Fall entweder durch eine kontinuierlich bestehende Kommunikationsverbindung oder eine temporär aufgebaute Kommunikationsverbindung zwischen den Distanzschutzgeräten 11a und 11b und der externen Recheneinrichtung 31 stattfinden. Finden die Messungen von Strom- und Spannungszeigermesswerten in den beiden Distanzschutzgeräten in nicht zeitsynchronisierter Weise statt, so muss eine beständige Kommunikationsverbindung zwischen den beiden Distanzschutzgeräten 11a und 11b und der Recheneinrichtung 31 bestehen, um eine nachträgliche Synchronisierung der Strom- und Spannungszeigermesswerte der unterschiedlichen Distanzschutzgeräte 11a oder 11b zu gewährleisten. Eine kontinuierliche Kommunikationsverbindung ist dann nicht mehr nötig, wenn die Strom- und Spannungszeigermesswerte in zeitsynchroner Weise aufgenommen werden und mit einem Zeitstempel versehen werden.

In diesem Fall ist es auch möglich, die Recheneinrichtung 31 nacheinander manuell mit den beiden Distanzschutzeinrichtungen 11a bzw. 11b in Verbindung zu bringen. Beispielsweise kann hierfür ein Datenkabel oder ein separater Datenträger, wie z.B. ein USB-Stick, verwendet werden, um die Strom- und Spannungszeigermesswerte von dem internen Datenspeicher des jeweiligen Distanzschutzgerätes 11a bzw. 11b auf die externe Recheneinrichtung 31 zu übermitteln.

In der externen Recheneinrichtung 31 finden die bereits im Zusammenhang mit Figuren 1 und 2 beschriebenen Schritte der Berechnung eines Fehlerortwertes m unter Verwendung eines zweiseitigen Fehlerortungsalgorithmus und die Berechnung des die Erdimpedanz angebenden Einstellwertes in entsprechender Weise statt. Der Einstellwert kann anschließend entweder manuell oder automatisch über eine bestehende Kommunikationsverbindung an die Distanzschutzgeräte 11a und 11b zur Einstellung des Parameters der Erdimpedanz zurück übertragen werden.

Auch bei dem Ausführungsbeispiel gemäß Figur 3 ist es möglich, anstelle von Distanzschutzgeräten 11a und 11b Zeigermessgeräte zu verwenden, die lediglich Strom- und Spannungszeiger messen und an die externe Datenverarbeitungseinrichtung übertragen.

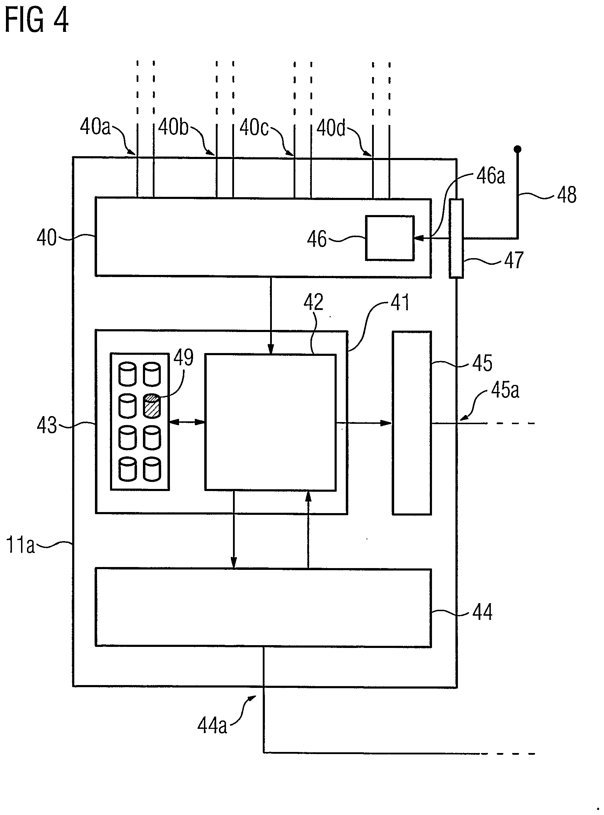

Figur 4 zeigt eine detaillierte Ansicht der Komponenten einer Messeinrichtung in Form des Distanzschutzgerätes 11a. Das Distanzschutzgerät 11a weist eine Erfassungseinrichtung 40 auf, die eingangsseitig mit Messeingängen 40a, 40b, 40c und 40d in Verbindung steht, über die Strom- und Spannungszeigermesswerte der drei Phasen und der elektrischen Erde erfasst werden. Die Erfassungseinrichtung 40 ist mit einer Datenverarbeitungseinrichtung 41 verbunden, die eine interne Recheneinrichtung 42, wie beispielsweise einen Mikroprozessor, und eine Speichereinrichtung 43 zum Abspeichern von Einstellwerten für das Distanzschutzgerät 11a aufweist. Die Datenverarbeitungseinrichtung 41 steht wiederum mit einer Kommunikationseinrichtung 44 in Verbindung, die über eine Sende- und Empfangsschnittstelle 44a verfügt. Außerdem steht die Datenverarbeitungseinrichtung 41 mit einem Kommandobaustein 45 in Verbindung, der ausgangsseitig einen Kommandoausgang 45a aufweist.

Die Erfassungseinrichtung 40 kann außerdem über einen internen Zeitgeber 46 verfügen, der die Abtastung der Strom- und Spannungszeigermesswerte der Messeingänge 40a bis 40d taktet. Der interne Zeitgeber 46 kann ferner über einen Synchronisationseingang 46a verfügen, der mit einem Empfänger für ein externes Zeitsignal 47, beispielsweise einem GPS-Empfänger, in Verbindung steht. Der Empfänger für das externe Zeitsignal 47 weist beispielsweise eine Antenne 48 auf, um das externe Zeitsignal zu empfangen.

Anstelle einer Antenne kann im Falle einer Übertragung des externen Zeitsignals beispielsweise über ein kabelgebundenes Netzwerk auch eine entsprechend andere Schnittstelle, beispielsweise eine Ethernet-Schnittstelle zum Empfangen eines über ein Ethernet-Netzwerk übertragenen externen Zeitsignals vorgesehen sein.

Die Datenverarbeitungseinrichtung 41 berechnet in bereits beschriebener Weise einen Einstellwert für die Erdimpedanz und speichert diesen als Erdimpedanz-Parameter 49 in der Speichereinrichtung 43 ab. In der Speichereinrichtung 43 sind üblicherweise auch andere Parameter, beispielsweise Leitungsimpedanz-Parameter und Kennlinien gespeichert.

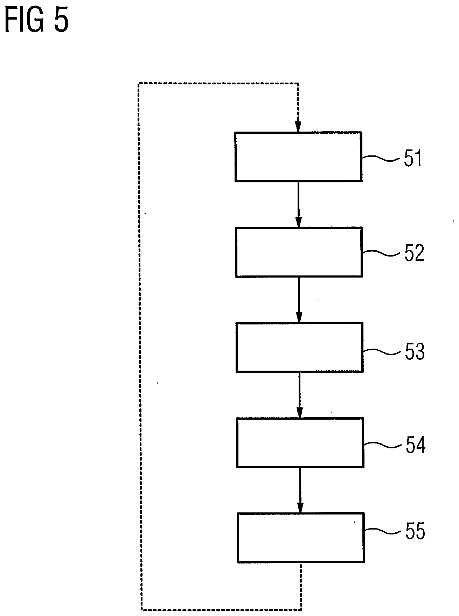

Zur Durchführung des Distanzschutzverfahrens kann die Recheneinheit 42 auf die Speichereinrichtung 43 zugreifen und den dort abgespeicherten Erdimpedanz-Parameter 49 zur Durchführung der Schutzalgorithmen abrufen. Das von der Datenverarbeitungseinrichtung 41 durchgeführte Verfahren soll noch einmal kurz unter Bezugnahme auf Figur 5 zusammengefasst werden.

Das Distanzschutzgerät 11a erfasst über die Messeingänge 40a bis 40d der Erfassungseinrichtung 40 in einem ersten Schritt 51 erste Strom- und Spannungszeigermesswerte. Die Erfassung der ersten Strom- und Spannungszeigermesswerte ist über den internen Zeitgeber 46 getaktet, der durch das über die Antenne 48 und den Empfänger 47 empfangene externe Zeitsignal synchronisiert ist. Die erfassten Strom- und Spannungszeigermesswerte werden an die Recheneinrichtung 42 der Datenverarbeitungseinrichtung 41 übertragen. Diese überprüft in einem zweiten Schritt 52, ob zumindest eine der drei Phasen von einem Kurzschluss betroffen ist. Hierzu greift die interne Recheneinrichtung 42 auf die in dem Datenspeicher 43 abgelegten Parameter, wobei bei einem Erdkurzschluss u.a. auch der Erdimpedanz-Parameter 49 verwendet wird.

Erkennt die Recheneinrichtung 42 einen Fehler auf einer der Phasen des Abschnitts 10 der elektrischen Energieübertragungsleitung, so wird ein Signal an den Kommandobaustein 45 abgegeben, der an seinem Kommandoausgang 45a einen Trip-Befehl für den entsprechenden Leistungsschalter abgibt, um die betroffene Phase des Abschnitts der elektrischen Energieübertragungsleitung von dem übrigen Energieübertragungsnetz zu isolieren.

Ist im Schritt 52 ein Fehler erkannt worden, so werden mittels der Kommunikationseinrichtung 44 in einem weiteren Schritt 53 zweite Strom- und Spannungszeigermesswerte, die an einem zweiten Distanzschutzgerät (beispielsweise dem Distanzschutzgerät 11b) erfasst worden sind, empfangen. Soll auch in dem zweiten Distanzschutzgerät eine Berechnung des Einstellwertes für die Erdimpedanz stattfinden, so werden im Schritt 53 auch die von dem ersten Distanzschutzgerät 11a selbst erfassten ersten Strom- und Spannungszeigermesswerte über die Kommunikationseinrichtung 44 an das zweite Distanzschutzgerät übertragen.

Die empfangenen zweiten Strom- und Spannungszeigermesswerte werden der Recheneinrichtung 42 zugeführt, die in einem folgenden Schritt 54 unter Verwendung der ersten und der zweiten Strom- und Spannungszeigermesswerte mittels eines zweiseitigen Fehlerortungsalgorithmus den Fehlerortwert m bestimmt.

Unter Verwendung des Fehlerortwertes m wird in einem abschließenden Schritt 55 ein Einstellwert für die Erdimpedanz berechnet. Hierzu wird beispielsweise Gleichung (4) verwendet.

Der auf diese Weise berechnete Einstellwert für die Erdimpedanz kann entweder sofort als neuer Parameter für die Erdimpedanz in den Datenspeicher 43 abgespeichert werden und somit den Parameter 49 für die Erdimpedanz ersetzen. Alternativ kann beispielsweise auch vorgesehen sein, dass ein Ersetzen des Parameters 49 für die Erdimpedanz nur dann stattfindet, wenn eine Mindestabweichung zwischen dem neu berechneten Einstellwert und dem bereits im Datenspeicher 43 vorliegenden Erdimpedanz-Parameter 49 vorliegt.

Wie bereits zuvor erwähnt, kann auch vorgesehen sein, dass zunächst eine gewisse Anzahl von Erdkurzschlüssen abgewartet wird und für jeden Erdkurzschluss in der beschriebenen Weise ein Einstellwert für die Erdimpedanz berechnet wird. Die jeweils berechneten Einstellwerten für die Erdimpedanz werden in den Datenspeicher 43 gespeichert. Sie werden allerdings nicht als Parameter 49 für die Erdimpedanz verwendet. Erst nachdem eine bestimmte Anzahl von Einstellwerten berechnet worden ist, wird ein Mittelwert über die zuvor berechneten Einstellwerte bestimmt und dieser Mittelwert als neuer Erdimpedanz-Parameter 49 in dem Distanzschutzgerät 11a eingestellt.

Die Einstellung des Parameters 49 entweder direkt aus jedem berechneten Einstellwert oder aus einem Mittelwert über mehrere berechnete Einstellwerte kann entweder automatisch von dem Distanzschutzgerät vorgenommen werden oder manuell von einem Bediener des Distanzschutzgerätes eingestellt werden. Im letztgenannten Fall gibt das elektrische Distanzschutzgerät 11a über ein in Figur 4 nicht gezeigtes Display dem Bediener einen Vorschlag zur Einstellung des Erdimpedanz-Parameters 49 an, so dass der Bediener des Distanzschutzgerätes 11a selbst entscheiden kann, ob er den vorgeschlagenen Wert als Erdimpedanz-Parameter 49 verwenden möchte oder nicht.

Das Verfahren gemäß Figur 5 kann kontinuierlich wiederholt werden, so dass adaptiv Veränderungen der Erdimpedanz in die Distanzschutzgeräte 11a bzw. 11b aufgenommen werden können.

**Patentansprüche**

1. Verfahren zum Bestimmen eines Einstellwertes für ein elektrisches Schutzgerät, bei dem

- beim Auftreten eines Erdkurzschlusses auf einem Abschnitt einer elektrischen Energieversorgungsleitung mit einer ersten Messeinrichtung (11a) erste Stromzeigermesswerte und erste Spannungszeigermesswerte an einem ersten Ende des Abschnitts (10) der elektrischen Energieversorgungsleitung und mit einer zweiten Messeinrichtung (11b)
zweite Stromzeigermesswerte und zweite Spannungszeigermesswerte an einem zweiten Ende des Abschnitts (10) der elektrischen Energieversorgungsleitung erfasst werden;

**dadurch gekennzeichnet, dass**

- unter Verwendung der ersten Strom- und Spannungszeigermesswerte und der zweiten Strom- und Spannungszeigermesswerte ein Fehlerortwert bestimmt wird, der einen Fehlerort angibt, an dem der Erdkurzschluss auf dem Abschnitt (10) der elektrischen Energieversorgungsleitung aufgetreten ist; und
- unter Verwendung des Fehlerortwertes ein eine Erdimpedanz angebender Einstellwert berechnet wird.

2. Verfahren nach Anspruch 1,
**dadurch gekennzeichnet, dass**

- der Einstellwert gemäß

$$\underline{Z}_E = \frac{\underline{U}_a - \underline{I}_{aL} m Z_L - \underline{U}_F}{m \underline{I}_{aE}}$$

berechnet wird, mit

$\underline{Z}_E$ : Erdimpedanz;
$\underline{U}_a$ : von der ersten Messeinrichtung (11a) gemessener Spannungszeiger;
$\underline{I}_{aL}$ : von der ersten Messeinrichtung (11a) gemessener Stromzeiger;
m : Entfernung von der ersten Messeinrichtung (11a) zum Fehlerort bezogen auf die Länge des Abschnitts (10) der Leitung;

$\underline{Z}_L$ : Mitsystemimpedanz des Abschnitts (10) der Leitung;
$\underline{U}_F$ : Spannungsabfall am Fehlerort;
$\underline{I}_{aE}$ : von der ersten Messeinrichtung (11a) gemessener Erdstrom.

3. Verfahren nach Anspruch 1 oder 2,
**dadurch gekennzeichnet, dass**

- die ersten Strom- und Spannungszeigermesswerte von der ersten Messeinrichtung (11a) und die zweiten Strom- und Spannungszeigermesswerte von der zweiten Messeinrichtung (11b) zeitsynchron erfasst werden.

4. Verfahren nach Anspruch 3,
**dadurch gekennzeichnet, dass**

- die ersten und zweiten Strom- und Spannungszeigermesswerte mit einem Zeitstempel versehen werden, der denjenigen Zeitpunkt angibt, zu dem die jeweiligen Strom- und Spannungszeigermesswerte erfasst worden sind.

5. Verfahren nach Anspruch 4,
**dadurch gekennzeichnet, dass**

- zur Erzeugung des Zeitstempels in der jeweiligen Messeinrichtung (11a, 11b) ein interner Zeitgeber (46) verwendet wird.

6. Verfahren nach Anspruch 5,
**dadurch gekennzeichnet, dass**

- die jeweiligen internen Zeitgeber (46) der Messeinrichtungen (11a, 11b) über einen gemeinsamen externen Zeitgeber synchronisiert werden.

7. Verfahren nach einem der vorangehenden Ansprüche,
**dadurch gekennzeichnet, dass**

- die erfassten zweiten Strom- und Spannungszeigermesswerte über eine Kommunikationsverbindung (14) von der zweiten Messeinrichtung (11b) an die erste Messeinrichtung (11a) übertragen werden.

8. Verfahren nach Anspruch 7,
**dadurch gekennzeichnet, dass**

- die erste Messeinrichtung (11a) den Fehlerortwert und den Einstellwert berechnet.

9. Verfahren nach einem der Ansprüche 1 bis 6,
**dadurch gekennzeichnet, dass**

- sowohl die ersten Strom- und Spannungszeigermesswerte von der ersten Messeinrichtung (11a) an die zweite Messeinrichtung (11b) als auch die zweiten Strom- und Spannungszeigermesswerte von der zweiten Messeinrichtung (11b) an die erste Messeinrichtung (11a) über eine Kommunikationsverbindung (14) übertragen werden.

10. Verfahren nach Anspruch 9,
**dadurch gekennzeichnet, dass**

- beide Messeinrichtungen (11a, 11b) den Fehlerortwert und den Einstellwert berechnen.

11. Verfahren nach einem der Ansprüche 1 bis 6,
**dadurch gekennzeichnet, dass**

- sowohl die ersten Strom- und Spannungszeigermesswerte von der ersten Messeinrichtung (11a) als auch die zweiten Strom- und Spannungszeigermesswerte von der zweiten Messeinrichtung (11b) an eine Recheneinrichtung (31) übertragen werden; und
- die Recheneinrichtung (31) den Fehlerortwert und den Einstellwert berechnet.

**12.** Verfahren nach einem der vorangehenden Ansprüche,
**dadurch gekennzeichnet, dass**

- der Einstellwert zur Einstellung eines Erdimpedanz-Parameters (49) eines elektrischen Distanzschutzgerätes verwendet wird.

**13.** Verfahren nach einem der Ansprüche 1 bis 11,
**dadurch gekennzeichnet, dass**

- für mehrere Erdkurzschlüsse jeweils ein Einstellwert berechnet wird; und
- aus den berechneten Einstellwerten ein Mittelwert bestimmt wird, der zur Einstellung eines Erdimpedanz-Parameters (49) eines Distanzschutzgerätes verwendet wird.

**14.** Messeinrichtung (z.B. 11a) mit

- einer Erfassungseinrichtung (40), die zur Erfassung von an einem ersten Ende eines Abschnitts (10) einer Energieübertragungsleitung anstehenden ersten Stromzeigermesswerten und ersten Spannungszeigermesswerten eingerichtet ist; und
- einer Kommunikationseinrichtung (44), die zum Empfangen von mittels einer weiteren Messeinrichtung (z.B. 11b) an einem zweiten Ende des Abschnittes (10) erfassten zweiten Stromzeigermesswerten und zweiten Spannungszeigermesswerten eingerichtet ist,

**dadurch gekennzeichnet, dass**

- die Messeinrichtung (11a) eine Datenverarbeitungseinrichtung (41) aufweist, die

- zur Berechnung eines den Ort eines Erdkurzschlusses auf dem Abschnitt (10) angebenden Fehlerortwertes aus den erfassten ersten Strom- und Spannungszeigermesswerten und den empfangenen zweiten Strom und Spannungszeigermesswerten und
- zur Berechnung eines eine Erdimpedanz angebenden Einstellwertes aus dem Fehlerortwert eingerichtet ist.

**15.** Messeinrichtung (11a) nach Anspruch 14,
**dadurch gekennzeichnet, dass**

- die Messeinrichtung (11a) ein elektrisches Distanzschutzgerät ist.

**Claims**

**1.** Method for determination of a setting value for an electrical protective device, in which,

- when a ground short occurs on a section of an electrical power supply line, a first measurement device (11a) is used to record first current phasor measured values and first voltage phasor measured values at a first end of the section (10) of the electrical power supply line, and a second measurement device (11b) is used to record second current phasor measured values and second voltage phasor measured values at a second end of the section (10) of the electrical power supply line;

**characterized in that**

- the first current and voltage phasor measured values and the second current and voltage phasor measured values are used to determine a fault location value, which indicates a fault location at which the ground short has occurred on the section (10) of the electrical power supply line; and
- the fault location value is used to calculate a setting value, which indicates a ground impedance.

**2.** Method according to Claim 1,
**characterized in that**

- the setting value is calculated using:

$$\underline{Z}_E = \frac{\underline{U}_a - \underline{I}_{aL}mZ_L - \underline{U}_F}{m\underline{I}_{aE}}$$

where

$\underline{Z}_E$ : ground impedance;
$\underline{U}_a$ : voltage phasor measured by the first measurement device (11a);
$\underline{I}_{aL}$ : current phasor measured by the first measurement device (11a);
m : distance from the first measurement device (11a) to the fault location, with respect to the length of the section (10) of the line;
$\underline{Z}_L$ : positive phase sequence system impedance of the section (10) of the line;
$\underline{U}_F$ : voltage drop at the fault location;
$\underline{I}_{aE}$ : ground current measured by the first measurement device (11a) .

3. Method according to Claim 1 or 2,
**characterized in that**

- the first current and voltage phasor measured values are recorded by the first measurement device (11a), and the second current and voltage phasor measured values are recorded by the second measurement device (11b), synchronously in time.

4. Method according to Claim 3,
**characterized in that**

- the first and second current and voltage phasor measured values are provided with a time stamp which indicates that point in time at which the respective current and voltage phasor measured values were recorded.

5. Method according to Claim 4,
**characterized in that**

- an internal timer (46) is used to produce the time stamp in the respective measurement device (11a, 11b).

6. Method according to Claim 5,
**characterized in that**

- the respective internal timers (46) of the measurement devices (11a, 11b) are synchronized via a common external timer.

7. Method according to one of the preceding claims,
**characterized in that**

- the recorded second current and voltage phasor measured values are transmitted via a communication link (14) from the second measurement device (11b) to the first measurement device (11a).

8. Method according to Claim 7,
**characterized in that**

- the first measurement device (11a) calculates the fault location value and the setting value.

9. Method according to one of Claims 1 to 6,
**characterized in that**

- the first current and voltage phasor measured values are transmitted from the first measurement device (11a) to the second measurement device (11b), and the second current and voltage phasor measured values are transmitted from the second measurement device (11b) to the first measurement device (11a) via a communication link (14).

10. Method according to Claim 9,
    **characterized in that**

    - both measurement devices (11a, 11b) calculate the fault location value and the setting value.

11. Method according to one of Claims 1 to 6,
    **characterized in that**

    - both the first current and voltage phasor measured values from the first measurement device (11a) and the second current and voltage phasor measured values from the second measurement device (11b) are transmitted to a computation device (31); and
    - the computation device (31) calculates the fault location value and the setting value.

12. Method according to one of the preceding claims,
    **characterized in that**

    - the setting value is used to set a ground impedance parameter (49) of an electrical distance protective device.

13. Method according to one of Claims 1 to 11,
    **characterized in that**

    - a setting value is calculated for each of a plurality of ground shorts; and
    - a mean value is determined from the calculated setting values and is used to set a ground impedance parameter (49) of a distance protective device.

14. Measurement device (for example 11a) having

    - a recording device (40), which is designed to record first current phasor measured values and first voltage phasor measured values which are present at a first end of a section (10) of a power transmission line; and
    - a communication device (44), which is designed to receive second current phasor measured values and second voltage phasor measured values which are recorded by means of a further measurement device (for example 11b) at a second end of the section (10),

    **characterized in that**

    - the measurement device (11a) has a data processing device (41), which is designed

        - to calculate a fault location value, which indicates the location of a ground short on the section (10), from the recorded first current and voltage phasor measured values and the received second current and voltage phasor measured values, and
        - to calculate a setting value, which indicates a ground impedance, from the fault location value.

15. Measurement device (11a) according to Claim 14,
    **characterized in that**

    - the measurement device (11a) is an electrical distance protective device.

**Revendications**

1. Procédé de détermination d'une valeur de réglage d'un appareil électrique de protection, dans lequel

    - à l'apparition d'un court-circuit à la terre sur un tronçon d'une ligne d'alimentation en énergie électrique, on relève par un premier dispositif (11a) de mesure, des premières valeurs de mesure de vecteur de courant et des premières valeurs de mesure de vecteur de tension à un premier bout du tronçon (10) de la ligne d'alimentation en énergie électrique et par un deuxième dispositif (11b) de mesure, on relève des deuxièmes valeurs de mesure de vecteur de courant et des deuxièmes valeurs de mesure de vecteur de tension à un second bout du tronçon (10) de la ligne d'alimentation en énergie électrique;

**caractérisé en ce que**

- on utilisant les premières valeurs de mesure de vecteur de courant et de tension et les deuxièmes valeurs de mesure de vecteur de courant et de tension, on détermine une valeur d'endroit de défaut, qui indique un endroit de défaut, où le court-circuit à la terre s'est produit sur le tronçon (10) de la ligne d'alimentation en énergie électrique; et
- en utilisant la valeur d'endroit de défaut, on calcule une valeur de réglage donnant une impédance de terre.

2. Procédé suivant la revendication 1,
   **caractérisé en ce que**

   - on calcule la valeur de réglage suivant

$$\underline{Z}_E = \frac{\underline{U}_a - \underline{I}_{aL} m Z_L - \underline{U}_F}{m \underline{I}_{aE}}$$

   avec

   $\underline{Z}_E$ : Impédance de terre;
   $\underline{U}_a$ : Vecteur de tension mesurée par le premier dispositif (11a) de mesure;
   $\underline{I}_{aL}$ : Vecteur de courant mesuré par le premier dispositif (11a) de mesure;
   m : Eloignement du premier dispositif (11a) de mesure par rapport à l'endroit de défaut rapporté à la longueur du tronçon (10) de la ligne;
   $\underline{Z}_L$ : Impédance de système direct du tronçon (10) de la ligne;
   $\underline{U}_F$ : Chute de tension à l'emplacement de défaut;
   $\underline{I}_{aE}$ : Courant de terre mesuré par le premier dispositif (11a) de mesure.

3. Procédé suivant la revendication 1 ou 2,
   **caractérisé en ce que**

   - on relève les premières valeurs de mesure de vecteur de courant et de tension par le premier dispositif (11a) de mesure et les deuxièmes valeurs de mesure de vecteur de courant et de tension par le deuxième dispositif (11b) de mesure en synchronisme dans le temps.

4. Procédé suivant la revendication 3,
   **caractérisé en ce que**

   - les première et deuxième valeurs de mesure de vecteur de courant et de tension sont pourvues d'un horodatage, qui indique l'instant où les valeurs de mesure de vecteur de courant et de tension ont été relevées.

5. Procédé suivant la revendication 4,
   **caractérisé en ce que**

   - pour produire l'horodatage, on utilise une horloge (46) interne dans le dispositif (11a, 11b) de mesure respectif.

6. Procédé suivant la revendication 5,
   **caractérisé en ce que**

   - on synchronise les horloges (46) internes respectives des dispositifs (11a, 11b) de mesure par une horloge extérieure commune.

7. Procédé suivant l'une des revendications précédentes
   **caractérisé en ce que**

- on transmet les deuxièmes valeurs de mesure de vecteur de courant et de tension, qui ont été relevées, du deuxième dispositif (11b) de mesure au premier dispositif (11a) de mesure par une liaison (14) de communication.

8. Procédé suivant la revendication 7,
   **caractérisé en ce que**

   - le premier dispositif (11a) de mesure calcule la valeur de l'emplacement du défaut et la valeur de réglage.

9. Procédé suivant l'une des revendications 1 à 6,
   **caractérisé en ce que**

   - on transmet, par une liaison (14) de communication, tant les premières valeurs de vecteur de courant et de tension du premier dispositif (11a) de mesure au deuxième dispositif (11b) de mesure, qu'également les valeurs de mesure de vecteur de courant et de tension du deuxième dispositif (11b) de mesure au premier dispositif (11a) de mesure.

10. Procédé suivant la revendication 9,
    **caractérisé en ce que**

    - les deux dispositifs (11a, 11b) de mesure calculent la valeur de l'emplacement du défaut et la valeur de réglage.

11. Procédé suivant l'une des revendications 1 à 6,
    **caractérisé en ce que**

    - on transmet, tant les premières valeurs de mesure de vecteur de courant et de tension du premier dispositif (11a) de mesure, qu'également les deuxièmes valeurs de mesure de vecteur de courant et de tension du deuxième dispositif (11b) de mesure à un dispositif (31) de calcul et
    - le dispositif (31) de calcul calcule la valeur de l'emplacement du défaut et la valeur de réglage.

12. Procédé suivant l'une des revendications précédentes,
    **caractérisé en ce que**

    - on utilise la valeur de réglage pour régler un paramètre (49) d'impédance à la terre d'un appareil électrique de protection à distance.

13. Procédé suivant l'une des revendications 1 à 11,
    **caractérisé en ce que**

    - on calcule, pour plusieurs court-circuits à la terre, respectivement, une valeur de réglage et
    - à partir des valeurs de réglage calculées, on détermine une valeur moyenne que l'on utilise pour régler un paramètre (49) d'impédance à la terre d'un appareil de protection à distance.

14. Dispositif (par exemple 11a) de mesure comprenant

    - un dispositif (40) de relevé, qui est conçu pour relever des premières valeurs de mesure de vecteur de courant et des premières valeurs de mesure de vecteur de tension apparaissant à un premier bout d'un tronçon (10) d'une ligne de transmission d'énergie et
    - un dispositif (44) de communication, conçu pour recevoir des deuxièmes valeurs de mesure de vecteur de courant et des deuxièmes valeurs de mesure de vecteur de tension relevées au moyen d'un autre dispositif (par exemple 11b) de mesure à un second bout du tronçon (10),

    **caractérisé en ce que**

    - le dispositif (11a) de mesure a un dispositif (41) de traitement de données, qui est conçu
    - pour calculer une valeur d'endroit du défaut indiquant l'endroit d'un court-circuit à la terre sur le tronçon (10) à partir des premières valeurs de mesure de vecteur de courant et de tension qui ont été détectées et des deuxièmes valeurs de mesure de vecteur de courant et de tension qui ont été reçues et
    - pour calculer, à partir de la valeur de l'endroit de défaut, une valeur de réglage donnant une impédance de terre.

**15.** Dispositif (11a) de mesure suivant la revendication 14,
**caractérisé en ce que**

- le dispositif (11a) de mesure est un appareil électrique de protection à distance.

FIG 1

## FIG 2

## FIG 3

# FIG 4

# FIG 5

**IN DER BESCHREIBUNG AUFGEFÜHRTE DOKUMENTE**

**In der Beschreibung aufgeführte Patentdokumente**

- EP 0795944 A2

- DE 4441334 C1